Europäisches Patentamt

European Patent Office

Office européen des brevets

(11) Publication number: **0 076 099**
**B1**

(12) **EUROPEAN PATENT SPECIFICATION**

(45) Date of publication of patent specification: 25.03.87

(51) Int. Cl.⁴: **H 03 K 19/088**

(21) Application number: 82305013.3

(22) Date of filing: 23.09.82

(54) **A TTL circuit.**

(30) Priority: 26.09.81 JP 152674/81
28.09.81 JP 151999/81

(43) Date of publication of application:
06.04.83 Bulletin 83/14

(45) Publication of the grant of the patent:
25.03.87 Bulletin 87/13

(84) Designated Contracting States:
DE FR GB

(56) References cited:
FR-A-1 532 506
US-A-4 228 371

PATENTS ABSTRACTS OF JAPAN, vol. 4, no.
97 (E-18)(579), July 12, 1980

IBM TECHNICAL DISCLOSURE BULLETIN, vol.
14, no. 8, January 1972, page 2289, New York,
US. W. B. CHIN: "T2L Compatible push-pull
drivers"

(73) Proprietor: FUJITSU LIMITED
1015, Kamikodanaka Nakahara-ku
Kawasaki-shi Kanagawa 211 (JP)

(72) Inventor: Tanizawa, Tetsu
Dai-2-Yurigaoka-ryo 2-7-5, Chiyogaoka Asao-ku
Kawasaki-shi Kanagawa 215 (JP)

(74) Representative: Sunderland, James Harry et al
HASELTINE LAKE & CO Hazlitt House
28 Southampton Buildings Chancery Lane
London WC2A 1AT (GB)

(56) References cited:
IBM TECHNICAL DISCLOSURE BULLETIN, vol.
21, no. 4, September 1978, pages 1454-1455,
New York, US. E. F. CULICAN et al.: "Schottky
clamp for transistor breakdown"

# Description

The present invention relates to a transistor-transistor logic (TTL) circuit. More particularly, it relates to a TTL inverter having a transient state of a high impedance output for reducing the transient current.

Transistor-transistor logic inverters are generally used as basic elements in semiconductor integrated circuits. Inverters constructed by PNP transistors or NPN transistors are known. In the following description, TTL inverters constructed with NPN transistors are explained. However, the present invention is also applicable to TTL inverters constructed with PNP transistors.

A conventional TTL inverter comprises a single phase-splitter transistor for splitting the phase of an input signal, which is applied to the base of the phase splitter transistor, into a noninverted phase given at its emitter and an inverted phase given at its collector; an inverted signal output transistor for inverting the signal of the noninverted phase; and an off buffer circuit connected in series with the inverting transistor and for receiving the inverted phase signal from the collector of the phase splitter transistor, whereby input signal applied to the input end is inverted and output at the output end. In principle, the off buffer circuit and the inverted signal output transistor are alternatively turned on and off in response to the outputs of the phase splitter transistor.

In the above-mentioned conventional TTL inverter, however, there are the following disadvantages. That is, in a transient period during which the output signal changes from the "H" (high) level to the "L" (low) level or vice versa, there is a period when both the off buffer circuit and the inverted signal output transistor are simultaneously conductive so that a large transient current flows therethrough. This transient current brings about not only an increase in power consumption but also a fluctuation of the power supply voltage, the fluctuation causing error operations of the external or internal circuits. Especially, in a large-scale integrated logic circuit, the transient currents in a number of inverters accumulate, resulting in a more serious problem in the above-mentioned error operations.

Secondly, when the off buffer circuit consists of a single transistor for obtaining an "H" level of the output voltage higher than the "H" level given by an off buffer circuit consisting of two transistors in a Darlington connection, a conventional TTL inverter requires a non-inverting gate connected between the collector of the phase splitter transistor and the off buffer circuit. The non-inverting gate comprises a number of elements. Because of the number of elements, the conventional TTL inverter of this type has a low integration degree and a low operating speed.

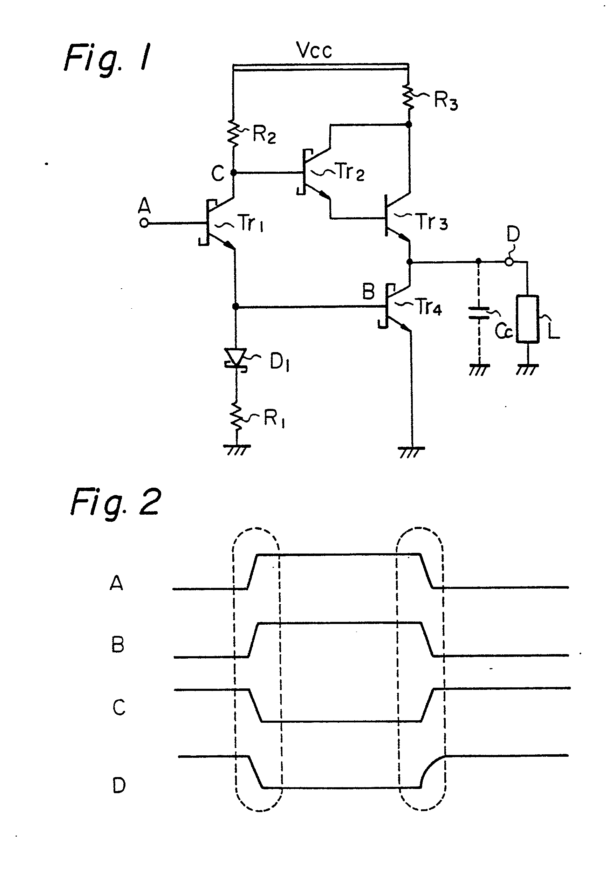

US—A—4 228 371 discloses a TTL inverter similar to the conventional TTL inverter described below with reference to Fig. 1.

Patent Abstracts of Japan, Vol. 4, No. 97 (E-18) (579), 12th July 1980 (concerning JP—A—5 560 339) discloses· a TTL circuit with two driver circuits which drive separately two transistor switch circuits at an output stage. No threshold voltage difference is present between transistor switch circuits in the output stage. Only conventional diodes are employed in the TTL circuit.

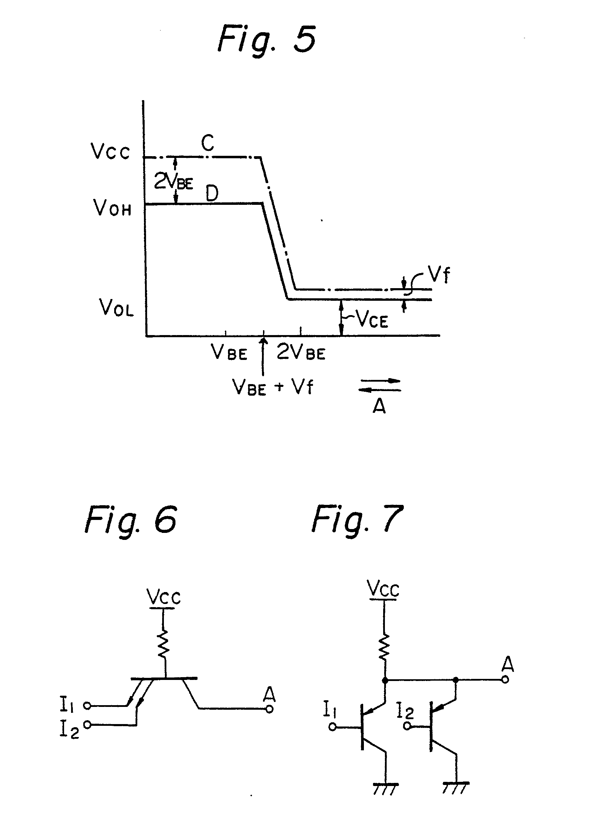

FR—A—1 532 506 discloses a TTL NAND gate which has different potentials at points in the circuit (see A and B in Fig. 6 of FR—A—1 532 506).

The NAND gate of Fig. 6 of FR—A—1532506 includes a first transistor (T2) having a base connected to the collector of a multi-emitter input transistor (T1) and a collector connected through a first resistor (R1) to a power supply line (Vcc), and a second transistor (T3) connected between the first transistor and an output (Y) of the gate with a base of the second transistor (T3) connected to an emitter of the first transistor (T2).

Voltage-divider resistors (R2, R3) are connected between the emitter of the first transistor (T2) and ground. The base of the second transistor (T3) is connected to the emitter of the first transistor (T2) through one (R2) of the voltage-divider transistors.

The circuit comprising T2, R2, R3, T3 has a threshold voltage determined by the base-emitter voltages of T2 and T3 and by the divided voltage provided by R2 and R3. When the signal received at the base of the first transistor (T2) is high the output (Y) is low.

A further transistor (T5) is connected between the output (Y) and the power supply line (Vcc). The further transistor (T5) is turned on, to make the output (Y) high, when the signal received at the base of the first transistor (T2) is low.

A third transistor (T2b) has a base connected through a second resistor (R4) to the emitter of the first transistor (T2), an emitter connected to ground, and a collector connected to the base of the further transistor (T5) and to the power supply line (Vcc) through a third resistor (R6).

The threshold voltage of the circuit comprising T2 and T2b is the sum of the base-emitter voltages of those transistors. This threshold voltage is lower than the threshold voltage of the circuit comprising T2, R2, R3, T3 so that the further transistor (T5) is turned off before turning on of T3 and is turned on after T3 is turned off.

According to the present invention there is provided:

A TTL circuit comprising

an input end for receiving an input signal;

an output end for providing a logic·output in response to said input signal;

an inverted signal output circuit, including a first transistor and a second transistor, said first transistor having a base connected to said input end and having a collector connected through a first resistor to a power supply line, said second transistor being connected between said first transistor and said output end with a base of the second transistor connected to an emitter of said first transistor, said inverted signal output circuit having a first threshold voltage substantially determined by the sum of the base emitter voltages of the first·and second transistors and being turned on when said input signal is at a high logic level to made said output end a low logic level;

an off-buffer circuit connected to said output end, said off-buffer circuit being turned on to make said output end a high logic level when said inputs signals are at a low logic level; and

an off-buffer driving circuit comprising a third transistor, connected between said input end and said off-buffer circuit, having a base connected through a second resistor to the input end, having an emitter connected through a Schottky diode to a ground supply line, and having a collector connected to a control electrode of said off-buffer circuit and through a third resistor to the power supply line,

said off-buffer driving circuit having a second threshold voltage, substantially determined by the sum of the base emitter voltage of the third transistor and the forward bias voltage of the Schottky diode, lower than the first threshold voltage of said inverted signal output circuit, whereby said off-buffer circuit is turned off before the turning on of said inverted signal output circuit and is turned on after said inverted signal output circuit is turned off.

An embodiment of the present invention can provide a TTL circuit which prevents the flow of transient current therethrough.

An embodiment of the present invention can provide a TTL circuit such that error operations in various circuits having a common power supply line with the TTL circuit (the error operations being caused by the fluctuation of the power supply voltage due to the transient current flowing through the TTL circuit) are prevented.

An embodiment of the present invention can provide a TTL circuit with reduced power consumption.

An embodiment of the present invention can provide for an increase in the integration degree in a TTL circuit.

An embodiment of the present invention can provide for an increase in the operating speed of the TTL circuit.

Reference is made, by way of example, to the accompanying drawings, in which:

Figure 1 is a circuit diagram illustrating an example of a conventional TTL inverter;

Figure 2 is a waveform diagram illustrating voltage waveforms at various nodes in the circuit of Figure 1;

Figure 3 is a graph for assistance in explaining a transient state which occurs when the circuit of Figure 1 is switching;

Figure 4 is a circuit diagram illustrating a TTL inverter according to an embodiment of the present invention;

Figure 5 is a graph for assistance in explaining a transient state which occurs when the circuit of Figure 4 is switching;

Figures 6 and 7 are circuit diagrams illustrating examples of circuits to be connected to the input end of the circuit of Figure 4;

Figure 8 is a circuit diagram illustrating a TTL inverter according to another embodiment of the present invention; and

Figure 9 is a circuit diagram illustrating another example of a conventional TTL inverter.

Before describing embodiments of the present invention, an example of a conventional TTL inverter and the disadvantages therein will be described with reference to Figures 1 through 3. In Figure 1, $Tr_1$ is a phase splitter transistor, the base of which operatively receives an input signal applied to an input end A connected to its base, the collector C of which provides an output having a phase inverted from that of the input signal, and the emitter of which provides another output having the same phase as the input signal. Transistors $Tr_2$ and $Tr_3$ in a Darlington connection constitute an off buffer circuit. "Off buffer" circuit will be described later. A transistor $Tr_4$ connected in series with the transistor $Tr_3$ is an inverted signal output transistor, the base B of which is connected to the emitter of the phase splitter transistor $Tr_1$. Between the emitter of the transistor $Tr_1$ and the ground, a diode $D_1$ and a resistor $R_1$ are connected in series. The diode $D_1$ and the resistor $R_1$ function to increase the switching speed of the inverted signal output transistor $Tr_4$ when it turns off, by drawing charges on its base to ground. An output end D is connected to a node commonly connected to the emitter of the transistor $Tr_3$ and the collector of the transistor $Tr_4$. A capacitor Cc connected to the output end D is a load capacitor of the output line. To the output end D, a load resistor L is connected. Vcc is power supply potential, $R_2$ and $R_3$ are resistors.

In the operation of the circuit of Figure 1, as illustrated in Figure 2, when the input signal applied to the input end A is at the "L" level, the transistor $Tr_1$ is in the off state so that, on the one hand, the base B of the transistor $Tr_4$ connected to the emitter of the transistor $Tr_1$ is at the "L" level, and, on the other hand, the base of the transistor $Tr_2$ connected to the collector C of the transistor $Tr_1$ is at the "H" level. Thus, in this state, the inverted signal output transistor $Tr_4$ is in the off state, and the off buffer circuit, consisting of the transistors $Tr_2$ and $Tr_3$, is in the on state so as to maintain the off state of the inverted signal output transistor $Tr_4$. In this state, therefore, the output end D is maintained at the "H" level. The name "off buffer" is derived from this function of keeping off the inverted signal output transistor $Tr_4$ and from the fact that this off buffer circuit includes the buffering transistor $Tr_2$.

When the input signal applied to the input end A is at the "H" level, the phase splitter transistor $Tr_1$ is in the on state so that its collector C is at the "L" level and its emitter connected to the base B of the inverted signal output transistor $Tr_4$ is at the "H" level. Accordingly, the output end D is at the "L" level.

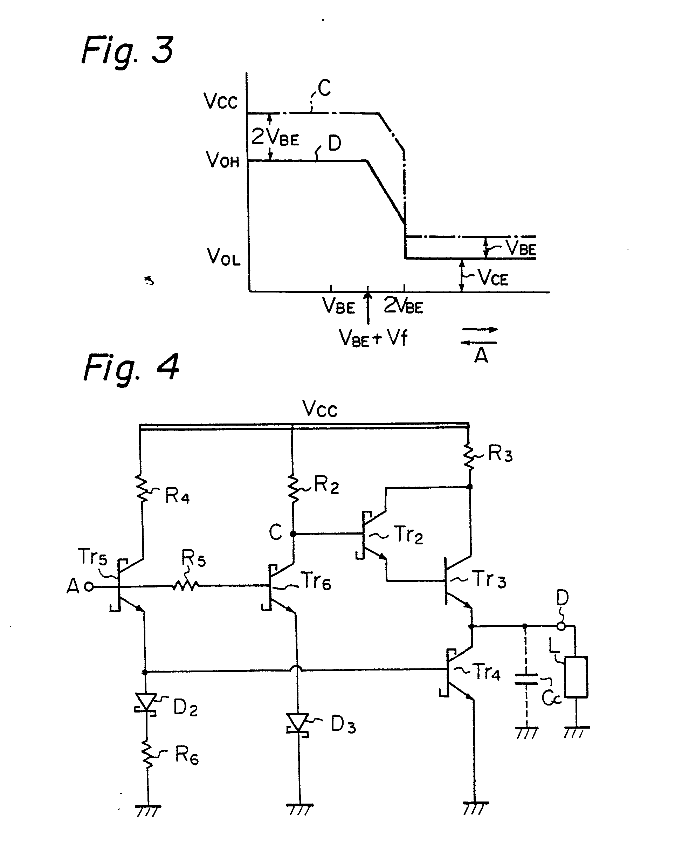

In the transient states as illustrated in Fig. 2 by the broken-line rings, however, there is a problem of a large transient current flowing through the transistors $Tr_3$ and $Tr_4$ in the conventional circuit of Fig. 1. The problem of the transient current, when the input A changes from the "L" level to the "H" level, will be explained with reference to Fig. 3. In the following description $V_{BE}$ (about 0.8 V) is the base-emitter voltage when the transistor $Tr_1$, $Tr_2$, $Tr_3$, or $Tr_4$ is conductive, $V_{CE}$ is the collector-emitter voltage of the transistor when it is saturated, and $V_f$ (about 0.5 V), which is lower than $V_{BE}$, is the anode-cathode voltage of the diode $D_1$ when it is conductive. In Fig. 3, when the input voltage applied to the input end A (horizontal axis) is lower than the sum of the base-emitter voltage $V_{BE}$ of the transistor $Tr_1$ and the anode-cathode voltage $V_f$ of the diode $D_1$, the transistor $Tr_1$ is in the off state so that its collector (C) potential (vertical axis) is equal to the power supply potential $V_{CC}$ and its emitter potential is equal to the ground potential. Therefore, the transistors $Tr_2$ and $Tr_3$ are conductive, and the transistor $Tr_4$ is not conductive, with the result that the output potential at the output end D is at a high logic level $V_{OH}$, which is nearly equal to $V_{CC}-2V_{BE}$, i.e., the base potential of the transistor $Tr_2$ minus the base-emitter voltage of the two stages of the transistors $Tr_2$ and $Tr_3$.

When the input voltage reaches $V_{BE} + V_f$ or more, the transistor $Tr_1$ begins to be turned on so that the potential at its collector C begins to be lowered, and, accordingly, the transistors $Tr_2$ and $Tr_3$ become unsaturated, with the result that the potential at the output end D is gradually lowered. Then, when the input voltage further increases to reach $2V_{BE}$, the transistors $Tr_1$ and $Tr_4$ are saturated so that they are completely turned on, with the result that the potential at the collector C is lowered to the sum of the collector-emitter voltage $V_{CE}$ of the transistor $Tr_1$ and the base-emitter voltage of the transistor $Tr_4$ and the potential at the output end D is lowered to the collector-emitter voltage $V_{CE}$ of the transistor $Tr_4$. Since the potential difference between the base of the transistor $Tr_2$ and the emitter of the transistor $Tr_3$ is now $(V_{CE} + V_{BE})-V_{CE} = V_{BE}$, the transistor $Tr_2$ is turned off. However, there are remaining charges on the base of the transistor $Tr_3$, so that, for an instant, the transistor $Tr_3$ is still in the on state even after the transistor $Tr_2$ is turned off. Therefore, there is an instantaneous current flowing from the power supply line $V_{CC}$ through the transistors $Tr_3$ and $Tr_4$ to the ground. This instantaneous current causes the abovementioned problem.

Although Fig. 3 illustrates input voltage at the input end A going higher than $2V_{BE}$, it cannot be increased to higher than $2V_{BE}$ because it is clamped to $2V_{BE}$ by the on-state transistors $Tr_1$ and $Tr_4$.

When the input voltage at the input end A is decreased from $2V_{BE}$ to the "L" level, a similar instantaneous current also flows through the transistors $Tr_3$ and $Tr_4$ because of the remaining charges on the base of the transistor $Tr_4$.

The primary object of the present invention is to prevent the above-mentioned instantaneous current from flowing through the transistors $Tr_3$ and $Tr_4$ during a transient period.

An embodiment of the present invention will now be described with reference to Figs. 4 and 5. In Fig. 4, the main difference between the conventional circuit of Fig. 1 and the circuit of Fig. 4 is that, in Fig. 4, instead of the single-phase splitter transistor $Tr_1$ in Fig. 1, two transistors $Tr_5$ and $Tr_6$ are employed. The transistor $Tr_5$ is used for driving only the inverted signal output transistor $Tr_4$. The transistor $Tr_6$ is used for driving only the off buffer circuit, including the transistors $Tr_2$ and $Tr_3$. The base of the transistor $Tr_5$ is connected to the input end A, its collector is connected through a resistor $R_4$ to the power supply line $V_{CC}$, and its emitter is connected to the base of the inverted signal output transistor $Tr_4$ and, through a diode $D_2$ and a resistor $R_6$ connected in series for drawing the charges on the base of the transistor $Tr_4$ when it turns on, to the ground. In place of the diode $D_2$ and the resistor $R_6$, a single resistor may alternatively be used. The base of the transistor $Tr_6$ is connected through a resistor $R_5$ to the input end A, its collector is connected to the base of the transistor $Tr_2$ in the off buffer circuit and, through a load resistor $R_2$, to the power supply line $V_{CC}$, and its emitter is connected through a Schottky diode $D_3$ to the ground. The resistor $R_5$ is provided for preventing the base potential of the transistor $Tr_6$ from being clamped to $V_{BE} + V_f$. That is, by providing the resistor $R_5$, the potential at the input end A can be increased to $2V_{BE}$. The transistors $Tr_2$ and $Tr_3$ constituting the off buffer circuit, the inverted signal output transistor $Tr_4$, the load capacitance Cc, and the load resistance L are the same as those in the circuit of Fig. 1.

The operation of the circuit of Fig. 4 will be described with reference to Fig. 5. When the potential of the input signal at the input end A is lower than $V_{BE} + V_f$, the transistors $Tr_5$ and $Tr_6$ are in the off state so that the transistors $Tr_2$ and $Tr_3$ are on and the transistor $Tr_4$ is off, resulting in a high potential level $V_{OH} = V_{CC}-2V_{BE}$ at the output end D. When the input potential at the input end A increases to more than $V_{BE} = V_f$, the transistor $Tr_6$ begins to be turned on so that the potential at its collector C begins to be lowered to the sum of its collector-emitter voltage and the anode-cathode voltage of the diode $D_3$ until the transistor $Tr_6$ is completely turned on and saturated. The transistors $Tr_2$ and $Tr_3$ are in the on state as long as the transistor $Tr_6$ is not saturated. Therefore, the potential at the emitter of the transistor $Tr_3$ connected to the ouput end D is lowered, as is the potential at the base of the transistor $Tr_2$ connected to the collector C of the transistor $Tr_6$. When the transistor $Tr_6$ is saturated, the transistor $Tr_2$ is not supplied with the base current so that the transistor $Tr_2$ and then the transistor $Tr_3$ are turned off. After the transistor $Tr_3$ is turned off, and when the input potential further increases to reach $2V_{BE}$, the transistor $Tr_4$ is turned on so that the output potential at the output end D is clamped to the low logic level $V_{OL}$ equal to $V_{CE}$ of the transistor $Tr_4$. Since the transistor $Tr_3$ is in the off state after the transistor $Tr_6$ is saturated, no transient current flows through the transistors $Tr_3$ and $Tr_4$.

During the switching period when the input potential is lowered from $2V_{BE}$ to a level lower than $V_{BE}$, the transistor $Tr_4$ is first turned off and then the transistor $Tr_6$ is turned off. Accordingly, the transistor $Tr_3$ is turned on only after the transistor $Tr_4$ is turned off. Thus, in this case also, no transient current flows through the transistors $Tr_3$ and $Tr_4$.

As is well known, to the input end A of the circuit of Fig. 4, a multiemitter transistor, as illustrated in Fig. 6, or an AND circuit comprising the PNP transistors, as illustrated in Fig. 7, may be connected. $I_1$ and $I_2$ are input terminals.

In the embodiment of Fig. 4, in order to obtain a high operating speed, Schottky barrier transistors are employed as the transistors $Tr_2$, $Tr_4$, $Tr_5$, and $Tr_6$. However, the scope of the present invention also covers the case when these transistors are not Schottky barrier transistors. Also, the transistors $Tr_2$ through $Tr_6$ may alternatively be PNP transistors.

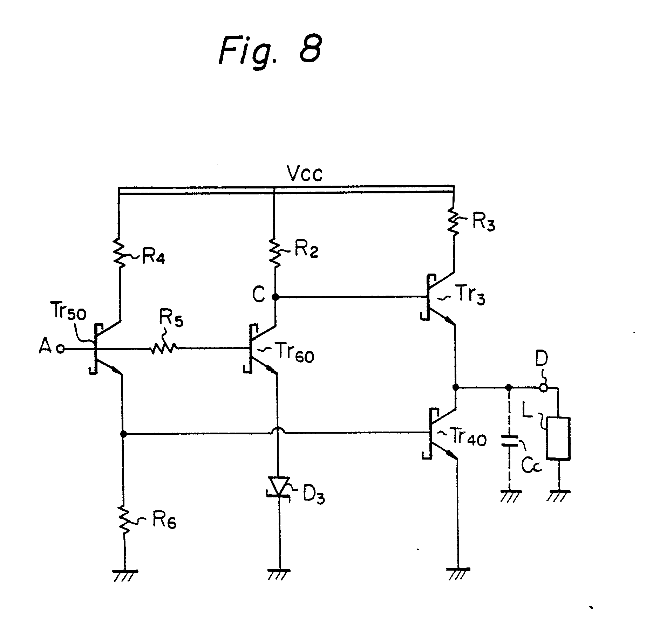

Figure 8 shows another embodiment of the present invention. The differences between Figs. 4 and 8 are that, in Fig. 8, the single transistor $Tr_3$, instead of the two transistors $Tr_2$ and $Tr_3$ of the off buffer circuit in Fig. 4, constitutes an off buffer circuit. By eliminating the transistor $Tr_2$ and by directly connecting the collector of a transistor $Tr_{60}$ to the base of the transistor $Tr_3$, the high logic level at the output end D of Fig. 8 is nearly equal to $V_{CC}-V_{BE}$, which is higher by $V_{BE}$ than the high logic level $V_{CC}-2V_{BE}$ at the output end D of Fig. 4. Conventionally, a TTL inverter having such a high "H" level output cannot be formed as simply as the circuit of Fig. 8. That is, in Fig. 8, when the output potential at the output end D is the "L" level, both transistors $Tr_{60}$ and $Tr_{40}$ are in the on state so that the potential difference between the collector C of the transistor $Tr_{60}$ and the output end D is $(V_{CE} + V_f)-V_{CE} = V_f$, which is lower than $V_{BE}$. Therefore, the transistor $Tr_3$ is surely off at this state. In contrast, in the conventional circuit of Fig. 1, if the transistor $Tr_2$ is eliminated and the collector of the transistor $Tr_1$ is directly connected to the base of the transistor $Tr_3$, the transistor $Tr_3$ would always be conductive because when the output potential is at the "L" level, the potential difference between C and D would be $V_{BE}$ so as to maintain the on state of the transistor $Tr_3$.

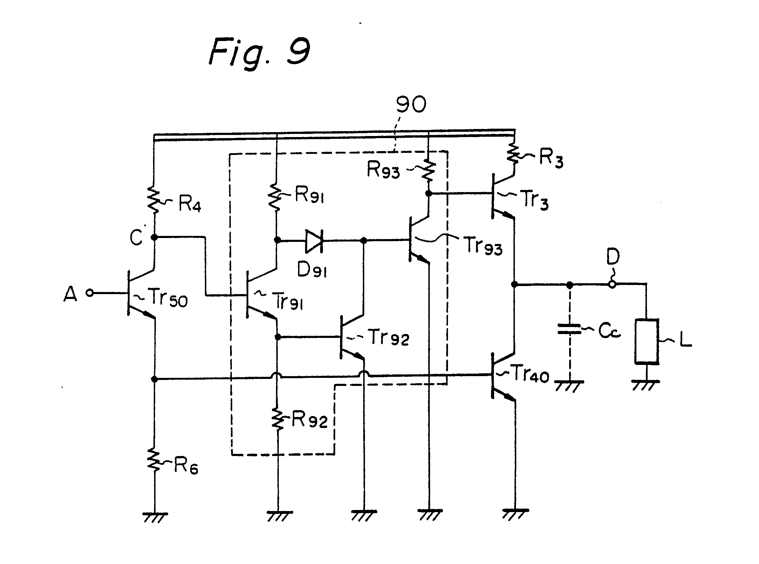

Conventionally, in order to obtain a TTL inverter having a relatively high "H" level output, a considerably complex circuit 90 was required between a phase splitting transistor $Tr_{50}$ and the off-buffer transistor $Tr_3$, as illustrated in Fig. 9. The circuit 90 acts as a noninverting gate. The noninverting gate 90 comprises a number of elements such as transistors $Tr_{91}$, $Tr_{92}$, and $Tr_{93}$, resistors $R_{91}$, $R_{92}$, and $R_{93}$, and a diode $D_{91}$. As

mentioned before, such a number of elements as the above-mentioned ones not only deteriorate the integration degree but also lower the operating speed. By comparing the circuit of Fig. 8 with the conventional circuit of Fig. 9, it will be apparent that the embodiment of Fig. 8 is advantageous in respect to the integration degree and the operating speed.

From the foregoing description, it will be apparent that, according to the present invention, in a TTL inverter, by separately providing two transistors for driving an off buffer circuit and for driving an inverted signal output transistor, respectively, and by making the input threshold voltage for turning on or off the one transistor different from that of another transistor, no transient current flows through the TTL inverter so that fluctuation of the power supply voltage due to the transient current can be prevented. Consequently, error operations of various circuits having a common power supply line with the TTL inverter can be prevented.

Further, according to the present invention, a TTL inverter having a relatively high "H" level output can easily be formed without decreasing the integration degree and the operating speed.

## Claims

1. A TTL circuit comprising
   an input end (A) for receiving an input signal;
   an output end (D) for providing a logic output in response to said input signal;
   an inverted signal output circuit ($Tr_5$, $Tr_4$) including a first transistor ($Tr_5$) and a second transistor ($Tr_4$), said first transistor having a base connected to said input end and having a collector connected through a first resistor ($R_4$) to a power supply line ($V_{CC}$), said second transistor ($Tr_4$) being connected between said first transistor and said output end with a base of the second transistor connected to an emitter of said first transistor, said inverted signal output circuit having a first threshold voltage substantially determined by the sum of the base emitter voltages ($V_{BE}$) of the first and second transistors and being turned on when said input signal is at a high logic level to make said output end a low logic level;
   an off-buffer circuit ($Tr_2$, $Tr_3$) connected to said output end, said off-buffer circuit being turned on to make said output end a high logic level when said inputs signals are at a low logic level; and
   an off-buffer driving circuit comprising a third transistor ($Tr_6$), connected between said input end and said off-buffer circuit, having a base connected through a second resistor ($R_5$) to the input end, having an emitter connected through a Schottky diode (D3) to a ground supply line, and having a collector connected to a control electrode of said off-buffer cirucit and through a third resistor ($R_2$) to the power supply line ($V_{CC}$), said off-buffer driving circuit having a second threshold voltage, substantially determined by the sum of the base emitter voltage of the third transistor and the forward bias voltage of the Schottky diode, lower than the first threshold voltage of said inverted signal output circuit, whereby said off-buffer circuit is turned off before the turning on of said inverted signal output circuit and is turned on after said inverted signal output circuit is turned off.

2. A TTL circuit as set forth in claim 1, wherein said off-buffer circuit comprises a fourth transistor (Tr$_2$) and a fifth transistor (Tr$_3$) in a Darlington connection, said fourth transistor having a base constituting the said control electrode of the off-buffer circuit, a first electrode connected through a further resistor (R$_3$) to said power supply line, and a second electrode, said fifth transistor (Tr$_3$) having a base connected to said second electrode of said fourth transistor (Tr$_2$), a first electrode connected to said first electrode of said fourth transistor, and a second electrode connected to said output end.

3. A TTL circuit as set forth in claim 1, wherein said off-buffer circuit comprises a single transistor (Tr$_3$) having a base connected to said collector of said third transistor (Tr$_6$), a first electrode connected through a further resistor (R$_3$) to said power supply line, and a second electrode connected to said output end.

4. A TTL circuit as set forth in claim 3, wherein said first, second, third, and fourth transistors are Schottky barrier transistors.

**Patentansprüche**

1. TTL-Schaltung mit
einem Eingangsende (A) zum Empfang eines Eingangssignals;
einem Ausgangsende (D) zur Lieferung eines logischen Ausgangs in Abhängigkeit von dem genannten Eingangssignal;
einer Invertersignal-Ausgangsschaltung (Tr$_5$, Tr$_4$), die einen ersten Transistor (Tr$_5$) und einen zweiten Transistor (Tr$_4$) umfaßt, von denen der genannte erste Transistor eine Basis hat, die mit dem genannten Eingangsende verbunden ist, und einen Kollektor, der über einen ersten Widerstand (R$_4$) mit einer Energieversorgung verbunden ist, der genannte Transistor (Tr$_4$) zwischen dem genannten ersten Transistor und dem genannten Ausgangsende verbunden ist, wobei eine Basis des zweiten Transistors mit einem Emitter des ersten Transistors verbunden ist, die genannte Invertersignal-Ausgangsschaltung eine erste Schwellenwertspannung hat, die im wesentlichen durch die Summe der Basisemitterspannung (V$_{BE}$) der ersten und zweiten Transistoren bestimmt ist und eingeschaltet wird, wenn das genannte Eingangssignal auf einem hohen logischen Pegel steht, um das genannte Ausgangsende zu einem niedrigen logischen Pegel zu machen;
einer Aus-Pufferschaltung (Tr$_2$, Tr$_3$), die mit dem genannten Ausgangsende verbunden ist und eingeschaltet wird, um das genannte Ausgangsende zu einem hohen logischen Pegel zu machen, wenn die Eingangssignale auf einem niedrigen logischen Pegel sind, und

einer Aus-Puffertrieberschaltung, die einen dritten Transistor (Tr$_6$) umfaßt, der zwischen dem genannten Eingangsende und der genannten Aus-Pufferschaltung verbunden ist und eine Basis hat, die über einen zweiten Widerstand (R$_5$) mit dem Eingangsende verbunden ist, und einen Emitter hat, der uber eine Schottky-Diode (D$_3$) mit einer Erdversorgungsleitung verbunden ist, und einen Kollektor hat, der mit einer Steuerelektrode der genannten Aus-Pufferschaltung und über einen dritten Widerstand (R$_2$) mit der Energieversorgungsleitung (V$_{cc}$) verbunden ist, wobei die Aus-Puffertrieberschaltung eine zweite Schwellenwertspannung hat, die im wesentlichen durch die Summe der Basisemitterspannung des dritten Transistors und die Vorwärtsspannung der Schottky-Diode bestimmt wird, niedriger als die erste Schwellen-wertspannung der genannten Invertersignal-Ausgangsschaltung, wodurch die genannte Aus-Pufferschaltung ausgeschaltet wird, bevor die genannte Invertersignal-Ausgangsschaltung eingeschaltet wird, und eingeschaltet wird, nachdem die genannte Invertersignal-Ausgangsschaltung ausgeschaltet ist.

2. Eine TTL-Schaltung nach Anspruch 1, bei der die genannte Aus-Pufferschaltung einen vierten Transistor (Tr$_2$) und einen fünften Transistor (Tr$_3$) in einer Darlington-Verbindung umfaßt, der vierte Transistor eine Basis hat, die die genannte Steuerelektrode der Aus-Pufferschaltung bildet, eine erste Elektrode, die über einen weiteren Widerstand (R$_3$) mit der genannten Energieversorgungsleitung verbunden ist, und eine zweite Elektrode, der fünfte Transistor (Tr$_3$) eine Basis hat, die mit der genannten zweiten Elektrode des genannten vierten Transistors (Tr$_2$) verbunden ist, eine erste Elektrode, die mit der genannten ersten Elektrode des genannten vierten Transistors verbunden ist, und eine zweite Elektrode, die mit dem genannten Ausgangsende verbunden ist.

3. Eine TTL-Schaltung nach Anspruch 1, bei der die genannte Aus-Pufferschaltung einen einzigen Transistor (Tr$_3$) umfaßt, der eine Basis hat, die mit dem genannten Kollektor des genannten dritten Transistors (Tr$_6$) verbunden ist, eine erste Elektrode, die über einen weiteren Widerstand (R$_3$) mit der genannten Energieversorgungsleitung verbunden ist, und eine zweite Elektrode, die mit dem genannten Ausgangsende verbunden ist.

4. Eine TTL-Schaltung nach Anspruch 3, bei der die genannten ersten, zweiten, dritten und vierten Transistoren Schottky-Sperrschichttransistoren sind.

**Revendications**

1. Circuit TTL comprenant
une extrémité d'entrée (A) pour recevoir un signal d'entrée;
une extrémité de sortie (D) pour délivrer un signal logique de sortie en réponse à ce signal d'entrée;
un circuit de sortie à signal inversé (Tr$_5$, Tr$_4$) comprenant un premier transistor (Tr$_5$) et un second transistor (Tr$_4$), le premier transistor étant relié par sa base à l'extrémité d'entre et par son collecteur à une ligne d'alimentation ($V_{CC}$), à travers une première résistance ($R_4$), le second transistor ($Tr_4$) étant monté entre le premier transistor et l'extrémité de sortie, en étant connecté par sa base à l'émetteur du premier transistor, le circuit de sortie à signal inversé présentant une première tension de seuil, déterminée essentiellement par la somme des tensions base-émetteur ($V_{BE}$) des premier et second transistors et ce circuit de sortie étant mis en conduction lorsque le signal d'entrée est au niveau haut, pour amener l'extrémité de sortie au niveau logique bas;

un circuit tampon bloqueur ($Tr_2$, $Tr_3$) connecté à l'extrémité de sortie et mis en conduction pour amener cette extrémité au niveau logique haut lorsque les signaux d'entrée sont au niveau logique bas; et

un circuit d'attaque du tampon bloqueur, comprenant un troisième transistor ($Tr_6$) monté entre l'extrémité d'entrée et le circuit tampon bloqueur, en étant connecté par sa base et à travers une deuxième résistance ($R_5$) à l'extrémité d'entrée, par son émetteur et à travers une diode Schottky (D3) à une ligne de masse et par son collecteur à une électrode de commande du circuit tampon bloqueur et, à travers une troisième résistance ($R_2$), à la ligne d'alimentation ($V_{CC}$), ce circuit d'attaque présentant une deuxième tension de seuil, déterminée essentiellement par la somme de la tension base-émetteur du troisième transistor et de la chute de tension directe de la diode Schottky, la deuxième tension de seuil étant inférieure à la première tension de seuil, celle du circuit de sortie à signal inversé, de sorte que le circuit tampon bloqueur est bloqué avant la mise en conduction du circuit de sortie à signal inversé et est mis en conduction après le blocage de ce circuit de sortie.

2. Circuit TTL selon la revendication 1, dans lequel le circuit tampon bloqueur comprend un quatrième transistor ($Tr_2$) et un cinquième transistor ($Tr_3$) dans un montage Darlington, le quatrième transistor constituant, par sa base, l'électrode de commande du circuit tampon bloqueur et possédant une première électrode qui est connectée à travers une résistance supplémentaire ($R_3$) à la ligne d'alimentation, de même qu'une deuxième électrode, le cinquième transistor ($Tr_3$) étant relié par sa base à la deuxième électrode du quatrième transistor ($Tr_2$) et possédant une première électrode qui est connectée à la première électrode du quatrième transistor, de même qu'une deuxième électrode connectée à l'extrémité de sortie.

3. Circuit TTL selon la revendication 1, dans lequel le circuit tampon bloqueur comprend un quatrième transistor ($Tr_3$) qui est connecté par sa base au collecteur du troisième transistor ($Tr_6$) et qui possède une première électrode connectée à travers une résistance supplémentaire ($R_3$) à la ligne d'alimentation, de même qu'une deuxième électrode connectée à l'extrémité de sortie.

4. Circuit TTL selon la revendication 3, dans lequel les premier, second, troisième, et quatrième transistors sont des transistors à barrière de Schottky.

*Fig. 1*

*Fig. 2*

# Fig. 3

# Fig. 4

## Fig. 5

## Fig. 6

## Fig. 7

# Fig. 8

## Fig. 9